(19) Europäisches Patentamt / European Patent Office / Office européen des brevets

(11) **EP 2 868 770 B1**

(12) **FASCICULE DE BREVET EUROPEEN**

(45) Date de publication et mention
de la délivrance du brevet:
**01.04.2020 Bulletin 2020/14**

(51) Int Cl.:
**C23C 16/04** *(2006.01)*    **C23C 16/40** *(2006.01)*
**C23C 16/44** *(2006.01)*    **C23C 16/455** *(2006.01)*

(21) Numéro de dépôt: **14190525.7**

(22) Date de dépôt: **27.10.2014**

(54) **DISPOSITIF D'ENCAPSULATION D'UN DISPOSITIF SENSIBLE ET PROCÉDÉ DE RÉALISATION DUDIT DISPOSITIF**

VORRICHTUNG ZUM EINKAPSELN EINER EMPFINDLICHEN VORRICHTUNG, UND HERSTELLUNGSVERFAHREN EINER SOLCHEN VORRICHTUNG

DEVICE FOR ENCAPSULATING A SENSITIVE DEVICE AND METHOD FOR MANUFACTURING SAID DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.10.2013 FR 1360521**

(43) Date de publication de la demande:
**06.05.2015 Bulletin 2015/19**

(73) Titulaire: **COMMISSARIAT À L'ÉNERGIE ATOMIQUE ET AUX ÉNERGIES ALTERNATIVES 75015 Paris (FR)**

(72) Inventeur: **OUKASSI, Sami 38120 SAINT-EGREVE (FR)**

(74) Mandataire: **Esselin, Sophie et al Marks & Clerk France Conseils en Propriété Industrielle Immeuble Visium 22 avenue Aristide Briand 94117 Arcueil Cedex (FR)**

(56) Documents cités:
WO-A1-2011/161632    WO-A1-2012/044522
WO-A1-2013/062486    US-A1- 2002 137 260
US-B1- 6 410 086

- ZHAVNERKO G ET AL: "Developing Langmuir@?Blodgett strategies towards practical devices", MATERIALS SCIENCE AND ENGINEERING B, ELSEVIER SEQUOIA, LAUSANNE, CH, vol. 169, no. 1-3, 25 mai 2010 (2010-05-25), pages 43-48, XP027038209, ISSN: 0921-5107 [extrait le 2010-05-01]
- Dayang Wang ET AL: "Synthesis of Macroporous Titania and Inorganic Composite Materials from Coated Colloidal SpheresA Novel Route to Tune Pore Morphology", Chemistry of materials, vol. 13, no. 2, 1 February 2001 (2001-02-01), pages 364-371, XP055466858, ISSN: 0897-4756, DOI: 10.1021/cm001184j

**Description**

Le domaine de l'invention est celui de l'encapsulation de dispositifs très sensibles et chimiquement instables. Ces dispositifs peuvent notamment être des microbatteries au lithium, les diodes électroluminescentes organiques OLED,.... De tels dispositifs présentent en général des matériaux très hygroscopiques et de ce fait doivent être protégés de l'atmosphère ambiante par un dispositif d'encapsulation possédant une ou plusieurs couches d'encapsulation. Le dispositif d'encapsulation doit présenter dans ce cas une très faible perméation à l'oxygène et à la vapeur d'eau (taux de transmission approximatif de $10^{-6}$ g.m$^{-2}$.jour$^{-1}$) et empêcher la diffusion de ces molécules vers les matériaux sensibles.

Plusieurs approches ont été abordées concernant la réduction de la perméation d'un dispositif d'encapsulation et l'augmentation de l'effet barrière. Ces approches se basent souvent sur deux principes :

- compartimenter les défauts de perméation, le principe consistant à créer plusieurs petits domaines pouvant être des billes, délimitées par une interface contrôlée ; par conséquent s'il y a un défaut de perméation (micro ou nano-fissure, micro ou nano-pore) qui traverse tout le volume de la bille et qui laisse pénétrer des molécules de $O_2/H_2O$ vers le système à encapsuler, ce défaut se trouve délimité par les domaines d'interface créés entre les billes, et la propagation est arrêtée au niveau de la bille. Le défaut est ainsi compartimenté dans un domaine, ce qui évite d'avoir des chemins continus de diffusion dans toute la structure ;
- allonger le chemin de diffusion (oxygène, vapeur d'eau) dans le dispositif d'encapsulation.

D'une manière générale, ces deux principes sont mis en œuvre par l'application de l'une (ou plusieurs) des méthodes suivantes :

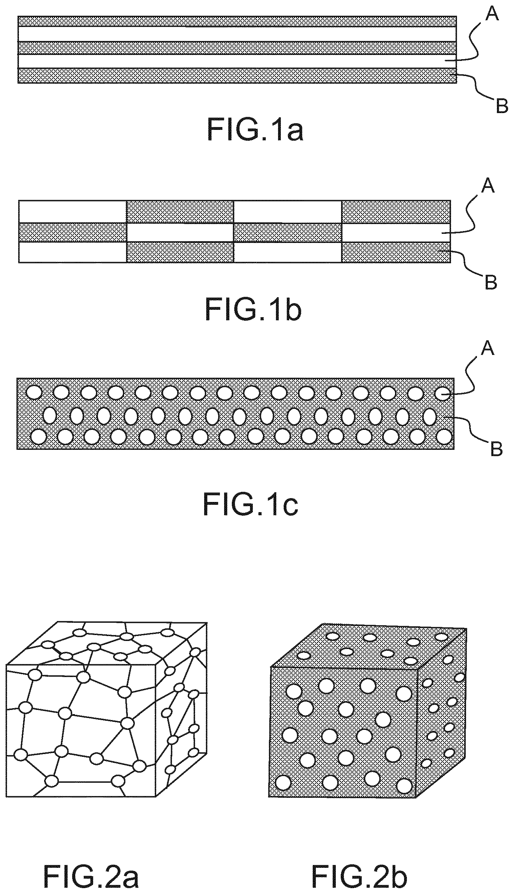

- une alternance de couches d'au moins deux matériaux A et B, dénommée nano ou micro « layering », comme schématisé en figure 1a. Cette méthode est mise en œuvre par exemple dans la demande de brevet WO2003094256 qui présente un empilement avec alternance de matériau organique/ inorganique. Cette solution permet d'allonger le chemin de diffusion et ainsi ralentir la cinétique de réaction des matériaux sensibles. La solution décrite dans ce document présente des inconvénients tels qu'une épaisseur trop importante de l'empilement complet pour certaines applications, ainsi qu'un coût très élevé de réalisation lié au nombre de dépôts ;
- la création de formes en surface ou en volume dans un matériau du dispositif d'encapsulation, dénommée : nano ou micro « texturing », comme schématisé en figure 1b, qui illustre des compartiments de matériau A et des compartiments de matériau B. Cette méthode est mise en œuvre par exemple dans la demande de brevet WO2008094352. L'empilement décrit dans cette demande comporte une ou plusieurs couches présentant au moins deux sections qui, une fois recouverte par une couche continue, permet de créer des discontinuités et compartimenter ainsi les défauts de perméation. Cette solution présente des inconvénients tels que l'incompatibilité de la technique de structuration (masque mécanique, gravure, ablation laser) avec la présence de matériaux sensibles en dessous de l'empilement d'encapsulation, ainsi qu'un coût très élevé de réalisation lié au nombre de dépôts et aux méthodes de structuration ;
- l'incorporation d'inclusions de matériau A dans une couche de l'empilement de matériau B, dénommée : nano ou micro « structuring », comme schématisé en figure 1c. Les inclusions sont des structures généralement actives, jouant souvent le rôle de site de piégeage d'oxygène ou vapeur d'eau, et sont communément appelés « getters ». Les demandes de brevet WO2008057045 et WO2013062486 décrivent des solutions utilisant le principe de la microstructuration. En effet, dans ces documents, il est proposé des particules dans une matrice polymère : la présence de couches composées de microparticules dans une matrice polymère et la présence de couche de microparticules fonctionnalisées enrobées dans un polymère. Ces solutions décrites dans ces documents présentent néanmoins des inconvénients, tels qu'une durée d'encapsulation effective liée à la durée jusqu'à saturation des particules « getters », ainsi que des épaisseurs importantes.

De plus, ces solutions ne proposent pas de structure ordonnée des particules et ne permettent pas la maîtrise des interfaces entre les particules.

Dans la publication Dayang Wang ET AL: "Synthesis of Macroporous Titania and Inorganic Composite Materials from Coated Colloidal SpheresA Novel Route to Tune Pore Morphology" (Chemistry of materials, vol. 13, no. 2, 1 février 2001, pages 364-371) un dispositif d'encapsulation comprenant des couches de particules colloïdales de Polystyrène ou de SiO2 revêtues de polystyrène disposées de façon géométrique avec une densité jusqu'à 71% est décrit.Les couches de particules sont infiltrées de façon à fermer les porosités avec de l'isoproxide de titane puis calcinées.

C'est pourquoi dans ce contexte la présente invention propose une solution apportant des performances accrues en termes d'encapsulation en raison d'une compacité élevée liée à une structure ordonnée des particules ainsi que la possibilité de déposer un ou plusieurs matériaux aux interfaces desdites particules. Cette combinaison de moyens contribue ainsi à améliorer les performances en termes de perméation.

Plus précisément la présente invention a pour objet un dispositif d'encapsulation comme décrit dans la revendication 1.

Ainsi le dispositif proposé peut constituer une solution pour un dispositif d'encapsulation faible épaisseur et faible coût permettant de s'affranchir des limitations précitées de l'art connu.

Ledit dispositif comprend un substrat sur lequel est réalisé ledit ensemble comportant lesdites particules.

Selon une variante de l'invention, le substrat peut être un support fonctionnel ou un capot.

Selon une variante de l'invention, ledit substrat présente une épaisseur de quelques dizaines de microns.

Selon une variante de l'invention, ladite structure géométrique est hexagonale compacte ou cubique face centrée.

Selon une variante de l'invention, lesdites particules sont recouvertes par au moins une première couche d'infiltration, en oxyde ou en nitrure ou en oxynitrure et une seconde couche d'infiltration en polymère pouvant appartenir à la famille des parylènes.

Selon une variante de l'invention, les particules ont des tailles comprises entre environ quelques dizaines de nanomètres et quelques microns.

Selon une variante de l'invention, les particules présentent au moins deux tailles différentes, permettant de réaliser un gradient de taille de particules, le gradient étant obtenu depuis le substrat, avec une succession de couches.

Selon une variante de l'invention, le dispositif comprend des particules d'au moins deux types de matériaux, un premier type de matériau présentant une perméabilité plus élevée pour les molécules de $O_2$ que pour les molécules de $H_2O$, le second type de matériau présentant une perméabilité plus élevée pour les molécules de $H_2O$ que pour les molécules de $O_2$

Selon une variante de l'invention, l'épaisseur de la couche d'infiltration est inférieure à environ un micron.

Selon une variante de l'invention, ledit ensemble de particules présente une épaisseur comprise entre environ 1 micron et 5 microns.

L'invention a aussi pour objet un dispositif comprenant un dispositif sensible et un dispositif d'encapsulation selon l'invention, disposé sur une face dudit dispositif sensible.

Selon une variante de l'invention, ledit dispositif d'encapsulation comporte un substrat pouvant être reporté sur le dispositif sensible.

Le dispositif sensible peut notamment être une microbatterie ou une diode électroluminescente organique.

Selon une variante de l'invention, le dispositif comprend une colle de scellement entre ledit dispositif sensible et ledit dispositif d'encapsulation.

L'invention a encore pour objet un procédé de réalisation de ce dispositif comme décrit dans la revendication 15.

Selon une variante de l'invention, l'ensemble compact de particules est réalisé par une technique de transfert d'un ensemble de monocouches de colloïdes dans un liquide de transfert à la surface d'un substrat.

Selon la présente invention, la couche poreuse de particules peut avantageusement être réalisée par une technique de Langmuir Blodgett, ou Langmuir Shaefer (ce type de technique consiste à transférer une ou plusieurs monocouches de particules sur un support et contrôler de manière précise la géométrie de la structure obtenue).

Selon une variante de l'invention, l'étape d'infiltration est réalisée par dépôt de couches minces atomiques, couramment dénommée « ALD » pour « Atomic layer Deposition ».

Selon une variante de l'invention, l'étape d'infiltration est réalisée par dépôt chimique en phase vapeur, couramment dénommé CVD pour « Chemical Vapor Déposition » ou dépôt chimique en phase vapeur assisté par plasma.

L'invention sera mieux comprise et d'autres avantages apparaîtront à la lecture de la description qui va suivre donnée à titre non limitatif et grâce aux figures annexées parmi lesquelles :

- les figures 1a, 1b et 1c illustrent des solutions d'encapsulation de l'art antérieur comprenant la combinaison de matériau A et de matériau B ;
- les figures 2a et 2b illustrent respectivement des ensembles à porosité ouverte et à porosité fermée ;
- la figure 3 illustre un ensemble comportant des particules dans une structure géométrique organisée et recouvertes d'au moins une couche infiltrée, dans un dispositif d'encapsulation selon l'invention ;
- la figure 4 illustre une vue agrandie d'un exemple de structure de particules utilisée dans l'invention dans laquelle les particules sont recouvertes de deux couches d'infiltration de manière à fermer la porosité ouverte de ladite structure ;
- les figures 5a et 5b illustrent un exemple de structure opale pouvant être utilisée dans une couche d'un dispositif d'encapsulation selon l'invention.

De manière générale, le dispositif d'encapsulation proposé dans la présente invention est composé d'au moins un ensemble de particules de grande compacité, c'est-à-dire présentant un fort taux de remplissage de l'espace par les particules, pouvant typiquement être supérieur à 50% et de préférence supérieur à 60 % ,sur un substrat donné et présentant une porosité ouverte.

La porosité ouverte est définie par un ensemble de pores connectés qui participe à la perméabilité d'un matériau et est illustrée en figure 2a. Il peut s'agir d'un réseau de vide au sein du matériau qui permet à un fluide, ou à un flux de molécules de le traverser en volume selon une direction de l'espace.

A l'inverse une porosité fermée est constituée par un ensemble de pores ne participant pas à la perméabilité et ne pouvant donc pas être accessibles par un fluide ou par un flux de molécules et est illustrée en figure 2b.

Selon l'invention, le réseau de vide est ainsi comblé au moins en partie par infiltration d'une ou plusieurs couches déposées.

Plus précisément, dans le cadre de l'invention, les pores sont les espaces vides entre les particules avant dépôt de la couche d'infiltration. Ces espaces vides sont connectés : il y a un chemin de percolation qui donne à l'ensemble formé par les particules sa perméabilité par rapport à un fluide donné ou un flux de molécules. Cela induit une perméation et par conséquent une dégradation des propriétés barrières de l'ensemble constitué par les particules, avant dépôt de la couche d'infiltration.

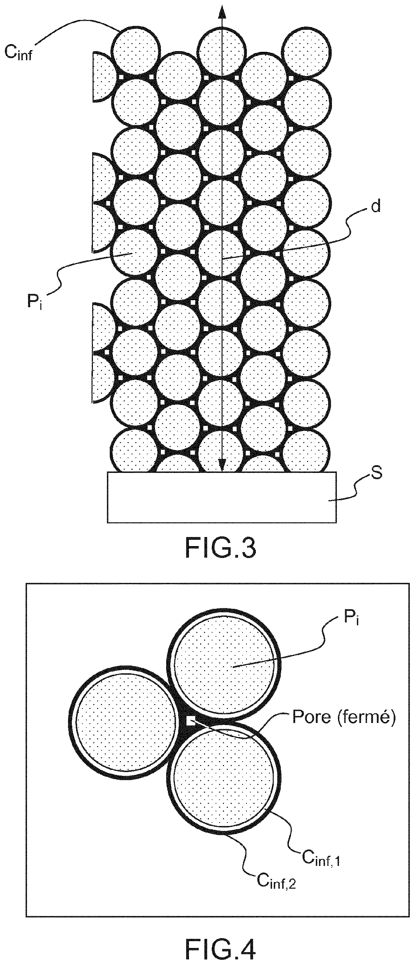

La figure 3 illustre un ensemble de particules organisées géométriquement et utilisé dans un dispositif d'encapsulation de l'invention. Des particules Pi sont disposées dans une structure organisée et sont recouvertes d'au moins une couche d'infiltration $C_{inf}$, à la surface d'un substrat S. L'ensemble d'une dizaine de particules empilées depuis le substrat, permet typiquement d'atteindre une hauteur d d'ensemble pouvant être de l'ordre de quelques microns.

Pour réaliser le dispositif d'encapsulation de la présente invention, il est nécessaire dans un premier temps de réaliser l'ensemble comprenant des particules organisées selon un type de structure géométrique donnée et présentant une porosité ouverte.

Une technique particulièrement adaptée repose sur une méthode de type Langmuir-Blodgett. Une telle méthode est notamment décrite dans l'article de Materials Science and Engineering B, vol 169-année 2010-pages 43-48).

On peut ainsi réaliser sur un substrat, un empilement de monocouches de particules sphériques par exemple de $SiO_2$ ou $Al_2O_3$, en structure opale, qui à l'échelle micrométrique est composé de sphères de silice (par exemple) hydratée de même diamètre (entre 150 et 300 nm) empilées soit en structure hexagonale compacte, soit en structure cubique faces centrées.

Selon l'invention toute autre structure est possible si elle permet d'obtenir un empilement de particules à forte compacité, typiquement supérieure à 60%. Il est à noter qu'une très forte compacité de 74 %, peut être obtenue pour l'empilement hexagonal compact et l'empilement cubique faces centrées.

Ainsi ces particules organisées de manière très compacte permettent d'assurer une très faible perméation, en empêchant le passage des molécules de type $O_2/H_2O$, en même temps qu'elles créent un ratio important en termes de surface extérieure billes/surface sur substrat et de ce fait permettent d'avoir un nombre extrêmement élevé de compartiments.

Dans un second temps on procède à l'opération dite d'infiltration d'une couche d'infiltration. Cette opération peut notamment être réalisée par des techniques de dépôt conforme telles que le dépôt de couches minces atomiques couramment dénommée (ALD) pour « Atomic layer Deposition », le principe consistant à exposer une surface successivement à différents précurseurs chimiques afin d'obtenir des couches ultra-minces d'infiltration, ou par dépôt chimique en phase vapeur assisté par plasma (PECVD) ou bien encore par dépôt chimique en phase vapeur (CVD) ou par dépôt chimique en phase vapeur à basse pression (LPCVD).

Ces techniques de dépôts permettent d'atteindre de très faibles épaisseurs de couche d'infiltration, typiquement inférieure au micron et de préférence inférieure à une centaine de nanomètres. La couche d'infiltration infiltre la structure et couvre toute la surface extérieure des particules, avantageusement des billes et forment ainsi le milieu interfacial inter-billes.

La ou les couches d'infiltration déposées comblent l'ensemble du volume de la porosité sauf une partie qui reste sous forme de poches de vide (séparées les unes des autres). La ou les couches d'infiltration couvrent la totalité de la surface développée de la structure sauf les points de contact entre les particules.

Cette (ou ces) couche d'infiltration qui est déposée sur une surface très large de l'ensemble des particules, permet ainsi :

- de combler des défauts de surface de billes ;
- de séparer les billes (compartiments) par un matériau à faible perméation ;
- d'augmenter le chemin de diffusion des molécules $O_2/H_2O$.

Avantageusement, une deuxième couche d'infiltration pouvant être de type polymère et par exemple un parylène, peut également être déposée et ce par polymérisation sous vide (telle que décrite dans l'article : IEEE transactions on advanced packaging, vol 30, issue 4, pp712-724, ou dans celui de Gorham W. F., 1966 : « A New, General Synthetic Method for the Preparation of Linear Poly-p-xylylene, J. Polym. Sci. Part A-1 Vol.4, p. 3027-3039 ». Il peut en effet être intéressant d'utiliser un matériau polymère, qui confère en plus, des propriétés mécaniques différentes de celles d'un matériau céramique, en termes notamment d'élasticité et de ductilité.

Par ailleurs l'intérêt d'utiliser plusieurs couches d'infiltration réside dans le fait d'augmenter le nombre d'interfaces et ainsi d'augmenter le chemin de diffusion.

Ainsi la structure décrite présente une compacité maximale des particules sphériques dans l'espace, qui présentent une porosité ouverte correspondant à un ensemble de pores connectés participant à la perméabilité d'un matériau.

La structure offre par ailleurs une surface totale extérieure des billes importante, permettant de créer autant d'interfaces entre les billes et ainsi compartimenter l'ensemble des domaines de défauts de perméation.

L'utilisation de dépôt conforme (permettant d'obtenir une couche d'épaisseur constante en tout point de la surface cible et épousant la forme des reliefs existant à la surface, ici la surface extérieure des billes) permet de remplir la porosité ouverte jusqu'à atteindre une compacité de 96% (et donc de réduire la porosité ouverte résiduelle à 4%). Au-delà de cette épaisseur de dépôt, la porosité ouverte se transforme en porosité fermée. La porosité fermée est localisée au niveau de la formation de poches de vide à des points de contacts des billes, ces poches de vide étant non connectées les unes aux autres donc localisées et formant une porosité fermée. La figure 4 illustre ainsi la porosité fermée localisée, dans le cas de particules Pi recouvertes de deux couches d'infiltration $C_{int,1}$ et $C_{int,2}$.

Cette compacité élevée et maitrisée est favorable à la réduction de porosité non maitrisée et autres défauts de perméation.

Ainsi, selon la présente invention, en formant des compartiments avec des billes ordonnées de manière très compacte, le peu de porosité est ensuite rempli de manière maitrisée par le dépôt de la ou des couches d'infiltration.

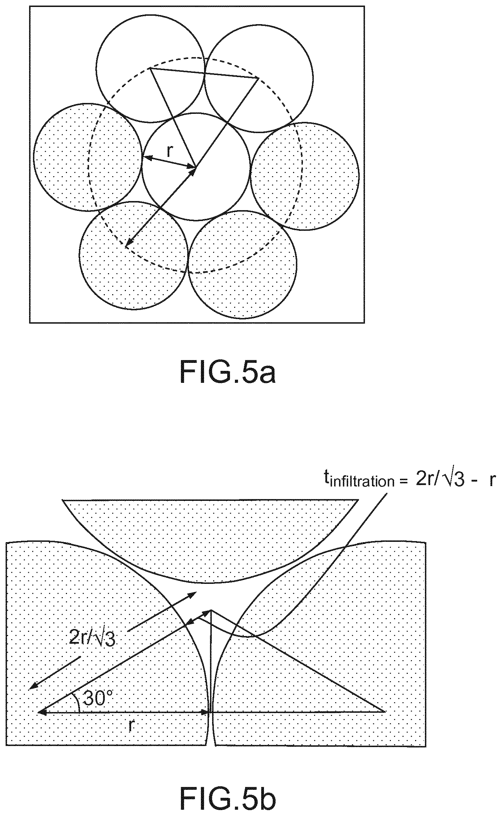

Dans le cadre d'une structure opale réalisée à partir de billes de silice et illustrée grâce aux figures 5a et 5b, on peut noter que l'épaisseur totale des couches d'infiltration est limitée par le facteur suivant : 0.15 x r, r étant le rayon d'une particule sphérique. En effet, la relation :
t infiltration = $(2\sqrt{3}-1)^* r = 0.15^*r$ fournit la condition de fermeture des pores, et donc t infiltration correspond à l'épaisseur maximale du film d'infiltration qu'on peut déposer. Au-delà de cette épaisseur de dépôt, la porosité ouverte se transforme en porosité fermée.

Il est mis en évidence dans le cas d'un empilement en opale, une forte compacité (74% avec un empilement maximal de sphères de même taille) et une surface développée $A_{opal}$ élevée, par rapport à la surface d'un film comprenant lesdites sphères $A_{film}$, lesdites surfaces étant liées par l'équation ci-après :

$$\frac{A_{opal}}{A_{film}} = \frac{0.74 \times l \times w \times t}{4/3\pi r^3} \times \frac{4\pi r^2}{l \times w} = \frac{2.22t}{r}$$

Avec r : rayon de la sphère ;
l et w étant respectivement la longueur et la largeur du film déposé, composé de sphères de rayon r, empilées sur une épaisseur t, la surface développée par les sphères Aopal est égale à 2.22*(t/r) fois la surface géométrique définie par le produit l.w.

Ainsi, on obtient typiquement pour r = 100nm et t = 5$\mu$m, une surface développée égale à 111 fois celle du film

Les avantages de l'empilement d'encapsulation de la présente invention sont notamment les suivants :

- la possibilité de contrôle de la taille, du matériau et du positionnement, en modifiant les paramètres du procédé de transfert de particules. Plus précisément, le positionnement est engendré par la possibilité de déposer les billes à des endroits et pas à d'autres, pour leur donner un motif particulier, par exemple sur une zone sensible à protéger et pas sur une zone inactive. permettant un large choix d'adaptation ;
- la possibilité d'alterner des types de particules sur les niveaux d'empilement, par exemple un premier type de particule présentant une perméabilité plus élevée pour les molécules de $O_2$ que pour celles de $H_2O$, et un second type de particule inverse du premier type, la combinaison améliorant ainsi le résultat final ;
- une seule étape de dépôt de couche d'infiltration (voire de deux) pour le traitement de l'ensemble de la structure organisée de particules, contrairement à une solution alternant les dépôts les uns après les autres pour créer des interfaces et allonger le chemin de diffusion des particules oxygène et/ou vapeur d'eau. Ceci contribue à réduire d'une manière conséquente le coût de réalisation à nombre d'interfaces égal ;
- l'obtention d'une architecture de dispositif permettant à la fois d'allonger le chemin de diffusion (oxygène, vapeur d'eau) et de compartimenter les défauts de perméation, d'une manière isotrope. Il est à noter que certaines solutions de l'art antérieur connu et notamment celle décrite dans la demande de brevet WO2008094352 décrivent également une solution permettant d'avoir un effet isotrope, néanmoins leurs inconvénients ont été mentionnés précédemment dans la présente description à savoir une incompatibilité entre les techniques de structuration laser, gravure. De telles méthodes sont des méthodes dites soustractives. En effet, on vient soustraire et enlever de la matière pour lui donner une certaine forme. En présence de dispositifs sensibles, l'application de ces méthodes nécessite une compatibilité technologique (thermique, chimique) avec les matériaux hygroscopiques, et une sélectivité (de gravure, d'ablation) pour enlever la matière souhaitée sans dégrader les matériaux sensibles. Ces techniques génèrent une difficulté de mise en œuvre accompagnée de coûts élevés.

Dans la présente invention, on a recours à une méthode dite additive. En effet, on dépose de la matière, sans contraintes de sélectivité permettant d'assurer une mise en œuvre plus simple et des coûts moins élevés. Le caractère isotrope est assuré non seulement dans le sens vertical au substrat (perméation verticale au dispositif) mais aussi dans le sens parallèle au substrat (perméation latérale au dispositif). L'effet isotrope et le niveau d'encapsulation sont uniformes dans l'empilement.

Dans le dispositif d'encapsulation de l'invention, les particules utilisées sont de préférence de forme sphérique pouvant être de même taille. Elles peuvent avoir des diamètres de particules compris entre 50nm et 5$\mu$m, de préférence entre 100 nm et 1$\mu$m. En effet, l"épaisseur totale de l'empilement étant fonction du diamètre des billes, plus le diamètre est petit et plus l'épaisseur totale est faible, facteur recherché dans de nombreuses applications. Néanmoins en dessous d'une certaine taille de particule, l'épaisseur possible de couche d'infiltration se trouve très faible (0.15xrayon) et donc plus complexe à réaliser).

Il est possible d'utiliser une alternance entre deux tailles différentes, permettant l'obtention d'un gradient de taille de particules et donc un gradient sur effet de perméation. Par exemple, il peut être envisagé dans un premier temps de déposer des particules de très petite taille pour couvrir une topographie de substrat élevée, puis augmenter la taille des particules pour déposer moins de couches.

Les particules peuvent être par exemple en matériaux de types oxydes, carbures, oxycarbures, ou polymères. Plus précisément, elles peuvent être en $SiO_2$ ou $Al_2O_3$ ou à base de carbure (SiC, WC, ZrC), ou bien encore de type oxycarbures tel que SiOC ou ZrOC.

Les particules peuvent également être en polymère, par exemple appartenant à la famille des parylènes, il peut s'agir plus précisément de PPX-C (Poly (chloro-p-xylylène)) ou de PPX-N (Poly (p-xylylène)) ou de PPX-D (Poly (dichloro-p-xylylène)).

Les couches d'infiltration pouvant être par exemple en composés de matériaux tels que : oxydes, nitrures, oxynitrures et polymères.

Avantageusement, la couche d'infiltration est en $Al_2O_3$ connu pour ses très bonnes propriétés d'encapsulation grâce à une faible perméation, la seconde couche étant en polymère de préférence en parylène capable d'être déposé de manière très conforme autour desdites particules et permettant ainsi d'allonger le chemin de diffusion des espèces $O_2/H_2O$.

Typiquement, dans le cas d'une structure opale, l'épaisseur totale des couches d'infiltration doit être supérieure à une valeur égale à 0.15 x rayon particule, afin de fermer la porosité de la structure.

Typiquement, l'épaisseur de la couche ainsi réalisée de particules recouvertes de couches d'infiltration peut être comprise entre 1 et 5$\mu$m.

Exemple de réalisation d'un empilement d'encapsulation de l'invention pour microbatterie :

On réalise sur un substrat verre fin, par exemple de 40$\mu$m d'épaisseur successivement :

- le dépôt de 10 monocouches de particules de $SiO_2$ sphériques de diamètre $\Phi$=500 nm (l'ensemble présentant une porosité ouverte) ;
- le dépôt d'une première couche d'infiltration de $Al_2O_3$ d'épaisseur de 30 nm par la technique de type ALD ;
- le dépôt d'une seconde couche d'infiltration de parylène PPX d'épaisseur de 20 nm par polymérisation sous vide.

L'épaisseur déposée totale (50 nm) des couches d'infiltration est suffisante pour permettre de transformer la porosité ouverte en porosité fermée.

Le dispositif d'encapsulation, encore appelé capot, constitué par le substrat et l'empilement des 10 monocouches, déposé par-dessus est ensuite reporté au-dessus d'un dispositif sensible, par exemple une microbatterie au lithium.

Le report du capot ainsi formé est réalisé par exemple par scellement polymère (polymérisation d'une colle entre le capot et le dispositif à protéger).

Une variante au précédent exemple consiste à déposer les monocouches directement sur le dispositif sensible, cependant le dépôt sur un substrat préalable, reporté ensuite sur le dispositif sensible permet d'éviter des contraintes de compatibilité (chimique, thermique, contrôle de l'atmosphère de dépôt...) entre les paramètres de dépôt de monocouches et le dispositif sensible.

**Revendications**

1. Dispositif d'encapsulation comprenant au moins un ensemble comportant des particules comprenant au moins un premier matériau d'oxyde ou de carbure ou d'oxycarbure, lesdites particules :

   ∘ étant réparties selon une structure ordonnée des particules présentant un taux de compacité desdites particules supérieur ou égal à 50% et de préférence supérieur à 60% et
   ∘ étant recouvertes de manière conforme par au moins une couche dite d'infiltration composée d'oxyde ou de parylène ;

   - ledit ensemble présentant une porosité fermée sous forme de pores non connectés les uns par rapport aux autres ;
   - ledit dispositif comprenant un substrat sur lequel est réalisé ledit ensemble comportant lesdites particules.

2. Dispositif d'encapsulation selon la revendication 1, **caractérisé en ce que** ledit substrat présente une épaisseur de quelques dizaines de microns.

3. Dispositif d'encapsulation selon l'une des revendications 1 à 2, **caractérisé en ce que** ladite structure ordonnée est hexagonale ou cubique face centrée.

4. Dispositif d'encapsulation selon l'une des revendications 1 à 3, **caractérisé en ce que** ledit ensemble comprend des particules d'au moins deux types de matériaux, un premier type de matériau présentant une perméabilité plus élevée pour des molécules de $O_2$ que pour des molécules de $H_2O$, le second type de matériau présentant une perméabilité plus élevée pour des molécules de $H_2O$ que pour des molécules de $O_2$.

5. Dispositif d'encapsulation selon l'une des revendications 1 à 4, **caractérisé en ce que** lesdites particules sont recouvertes par au moins une première couche d'infiltration en oxyde et une seconde couche d'infiltration en polymère appartenant à la famille des parylènes.

6. Dispositif d'encapsulation selon l'une des revendications 1 à 5, **caractérisé en ce que** la couche d'infiltration est en $Al_2O_3$.

7. Dispositif d'encapsulation selon l'une des revendications 1 à 6, **caractérisé en ce que** les particules ont des tailles comprises entre quelques dizaines de nanomètres et quelques microns.

8. Dispositif d'encapsulation selon l'une des revendications 1 à 7, **caractérisé en ce qu'**il présente un gradient de taille de particules, le gradient étant obtenu depuis le substrat, avec une succession de couches

9. Dispositif d'encapsulation selon l'une des revendications 1 à 8, **caractérisé en ce que** l'épaisseur de la couche d'infiltration est inférieure ou égale à un micron.

10. Dispositif d'encapsulation selon l'une des revendications 1 à 9, **caractérisé en ce que** ledit ensemble comprenant lesdites particules présente une épaisseur comprise entre 1 micron et 5 microns.

11. Dispositif comprenant un dispositif sensible à l'oxygène et à la vapeur d'eau et un dispositif d'encapsulation selon l'une des revendications 1 à 10, disposé sur une face dudit dispositif sensible à l'oxygène et à la vapeur d'eau.

12. Dispositif selon la revendication 11 **caractérisé en ce que** le dispositif sensible est une microbatterie.

13. Dispositif selon la revendication 11 **caractérisé en ce que** le dispositif sensible est une diode électroluminescente organique.

14. Dispositif selon l'une des revendications 11 à 13 **caractérisé en ce qu'**il comprend une colle de scellement entre ledit dispositif sensible et ledit dispositif d'encapsulation.

15. Procédé de réalisation d'un dispositif d'encapsulation selon l'une des revendications 1 à 10, **caractérisé en ce qu'**il comprend les étapes suivantes :

- la réalisation d'un ensemble comportant des particules comprenant au moins un premier matériau, ledit ensemble présentant une porosité ouverte, lesdites particules étant réparties selon une structure ordonnée des particules présentant un taux de compacité desdites particules supérieur ou égal à 50% et de préférence supérieur à 60 % ;

- ladite réalisation de l'ensemble étant effectuée par une technique de transfert d'un ensemble de monocouches de colloïdes dans un liquide de transfert à la surface d'un substrat ;

- l'infiltration dudit ensemble de particules par au moins une couche d'infiltration déposée par une technique conforme, permettant de déposer ladite couche d'infiltration autour desdites particules et de fermer ladite porosité ouverte avant cette étape de dépôt, sous forme de pores non connectés les uns par rapport aux autres ;

- ladite infiltration étant effectuée par (ALD) pour « Atomic layer Déposition », ou par dépôt chimique en phase vapeur assisté par plasma (PECVD) ou par dépôt chimique en phase vapeur (CVD) ou par dépôt chimique en phase vapeur à basse pression (LPCVD)

**16.** Procédé de réalisation d'un dispositif d'encapsulation selon la revendication 15 **caractérisé en ce que** la technique de transfert est une technique de transfert de Langmuir Blodgett, ou de Langmuir Shaefer.


**Patentansprüche**

**1.** Vorrichtung zum Einkapseln, beinhaltend mindestens eine Anordnung, welche Partikel beinhaltet, welche mindestens ein erstes Oxid- oder Karbid- oder Oxikarbidmaterial beinhalten, wobei die Partikel:

◦ entsprechend einer geordneten Struktur der Partikel verteilt sind, welche einen Kompaktheitsgrad der Partikel größer oder gleich 50 % und vorzugsweise größer als 60 % aufweist und
◦ regulär durch mindestens eine Infiltrationsschicht genannte Schicht, gebildet aus Oxid oder aus Parylen, bedeckt sind;

- wobei die Anordnung eine geschlossene Porosität in Form von nicht miteinander verbundenen Poren aufweist;
- wobei die Vorrichtung ein Substrat beinhaltet, auf welchem die Anordnung, welche die Partikel beinhaltet, hergestellt ist.

**2.** Vorrichtung zum Einkapseln nach Anspruch 1, **dadurch gekennzeichnet, dass** das Substrat eine Dicke von einigen Zehn Mikrometern aufweist.

**3.** Vorrichtung zum Einkapseln nach einem der Ansprüche 1 bis 2, **dadurch gekennzeichnet, dass** die geordnete Struktur sechseckig oder kubisch flächenzentriert ist.

**4.** Vorrichtung zum Einkapseln nach einem der Ansprüche 1 bis 3, **dadurch gekennzeichnet, dass** die Anordnung Partikel aus mindestens zwei Materialarten beinhaltet, wobei eine erste Materialart eine größere Permeabilität gegenüber $O_2$-Molekülen als gegenüber $H_2O$-Molekülen aufweist, wobei die zweite Materialart eine größere Permeabilität gegenüber $H_2O$-Molekülen als gegenüber $O_2$-Molekülen aufweist.

**5.** Vorrichtung zum Einkapseln nach einem der Ansprüche 1 bis 4, **dadurch gekennzeichnet, dass** die Partikel durch mindestens eine erste Infiltrationsschicht aus Oxid und durch eine zweite Infiltrationsschicht aus Polymer, welches zu der Familie der Parylene gehört, bedeckt sind.

**6.** Vorrichtung zum Einkapseln nach einem der Ansprüche 1 bis 5, **dadurch gekennzeichnet, dass** die Infiltrationsschicht aus $Al_2O_3$. besteht.

**7.** Vorrichtung zum Einkapseln nach einem der Ansprüche 1 bis 6, **dadurch gekennzeichnet, dass** die Partikel Größen besitzen, welche zwischen einigen Zehn Nanometern und einigen Mikrometern liegen.

**8.** Vorrichtung zum Einkapseln nach einem der Ansprüche 1 bis 7, **dadurch gekennzeichnet, dass** sie einen Partikelgrößengradienten aufweist, wobei der Gradient vom Substrat aus mit einer Abfolge von Schichten erzielt wird.

**9.** Vorrichtung zum Einkapseln nach einem der Ansprüche 1 bis 8, **dadurch gekennzeichnet, dass** die Dicke der Infiltrationsschicht kleiner als ein oder gleich einem Mikrometer ist.

**10.** Vorrichtung zum Einkapseln nach einem der Ansprüche 1 bis 9, **dadurch gekennzeichnet, dass** die Anordnung, welche die Partikel beinhaltet, eine Dicke zwischen 1 Mikrometer und 5 Mikrometern aufweist.

**11.** Vorrichtung, beinhaltend eine sauerstoff- und wasserdampfempfindliche Vorrichtung und eine Vorrichtung zum Einkapseln nach einem der Ansprüchel bis 10, welche an einer Seite der sauerstoff- und wasserdampfempfindlichen Vorrichtung angeordnet ist.

**12.** Vorrichtung nach Anspruch 11, **dadurch gekennzeichnet, dass** die empfindliche Vorrichtung eine Mikrobatterie ist.

**13.** Vorrichtung nach Anspruch 11, **dadurch gekennzeichnet, dass** die empfindliche Vorrichtung eine organische Leuchtdiode ist.

**14.** Vorrichtung nach einem der Ansprüche 11 bis 13, **dadurch gekennzeichnet, dass** sie einen Versiegelungsklebstoff zwischen der empfindlichen Vorrichtung und der Vorrichtung zum Einkapseln beinhaltet.

**15.** Herstellungsverfahren einer Vorrichtung zum Einkapseln nach einem der Ansprüche 1 bis 10, **dadurch gekennzeichnet, dass** es folgende Schritte beinhaltet:

- Herstellen einer Anordnung, welche Partikel beinhaltet, welche mindestens ein erstes Material beinhalten, wobei die Vorrichtung eine offene Porosität aufweist, wobei die Partikel entsprechend einer geordneten Struktur der Partikel verteilt sind, welche einen Kompaktheitsgrad der Partikel größer oder gleich 50 % und vorzugsweise größer oder gleich 60 % aufweisen;
- wobei die Herstellung der Anordnung anhand einer Transfertechnik einer Anordnung von Einzelschichten von Kolloiden in einer Transferflüssigkeit auf die Oberfläche eines Substrates erfolgt;
- Infiltration der Anordnung von Partikeln mit mindestens einer Infiltrationsschicht, welche durch eine reguläre Technik abgelagert wird, die es ermöglicht, die Infiltrationsschicht um die Partikel abzulagern und die vor diesem Ablagerungsschritt offene Porosität in Form von nicht miteinander verbundenen Poren zu verschließen;
- wobei die Infiltration anhand von (ALD), Abkürzung von "Atomic layer Deposition" oder anhand von plasmagestützter chemischer Dampfablagerung (PECVD) oder anhand von chemischer Dampfablagerung (CVD) oder anhand von chemischer Dampfablagerung bei Niederdruck (LPCVD) bewerkstelligt wird.

**16.** Verfahren zur Herstellung einer Vorrichtung zum Einkapseln nach Anspruch 15, **dadurch gekennzeichnet, dass** die Transfertechnik eine Langmuir-Blodgett-, oder eine Langmuir-Shaefer-Transfertechnik ist.

**Claims**

**1.** Encapsulation device comprising at least one assembly containing particles comprising at least a first material made of oxide or carbide or oxycarbide, said particles:

∘ being distributed over an ordered structure of the particles that has a degree of compactness of said particles greater than or equal to 50% and preferably greater than 60% and
∘ being covered conformally by at least one layer referred to as an infiltration layer composed of oxide or parylene;

- wherein said assembly has a closed porosity in the form of pores which are not connected to one another;
- wherein said device comprises one substrate on which said assembly containing said particles is produced.

**2.** Encapsulation device according to claim 1, **characterized in that** said substrate has a thickness of a few tens of microns.

**3.** Encapsulation device according to one of claims 1 to 2, **characterized in that** said ordered structure is hexagonal or face-centered cubic.

**4.** Encapsulation device according to one of claims 1 to 3, **characterized in that** said assembly comprises particles of at least two types of materials, a first type of material having a higher permeability for $O_2$ molecules than for $H_2O$ molecules, the second type of material having a higher permeability for $H_2O$ molecules than for $O_2$ molecules.

**5.** Encapsulation device according to one of claims 1 to 4, **characterized in that** said particles are covered with at least a first infiltration layer made of oxide and a second infiltration layer made of polymer belonging to the family of parylenes.

6. Encapsulation device according to one of claims 1 to 5, **characterized in that** the infiltration layer is made of $Al_2O_3$.

7. Encapsulation device according to one of claims 1 to 6, **characterized in that** the particles have sizes ranging between a few tens of nanometres and a few microns.

8. Encapsulation device according to one of claims 1 to 7, **characterized in that** it has a particle size gradient, the gradient being obtained going from the substrate, with a succession of layers.

9. Encapsulation device according to one of claims 1 to 8, **characterized in that** the thickness of the infiltration layer is less than or equal to one micron.

10. Encapsulation device according to one of claims 1 to 9, **characterized in that** said assembly comprising said particles has a thickness between 1 micron and 5 microns.

11. Device comprising a device which is sensitive to oxygen and water vapour and an encapsulation device according to one of claims 1 to 10, positioned on one face of said device which is sensitive to oxygen and water vapour.

12. Device according to claim 11, **characterized in that** the sensitive device is a microbattery.

13. Device according to claim 11, **characterized in that** the sensitive device is an organic light-emitting diode.

14. Device according to one of claims 11 to 13, **characterized in that** it comprises a sealing adhesive between said sensitive device and said encapsulation device.

15. Process for producing an encapsulation device according to one of claims 1 to 10, **characterized in that** it comprises the following steps:

- production of an assembly containing particles, comprising at least a first material, said assembly having an open porosity, said particles being distributed over an ordered structure of the particles having a degree of compactness of said particles greater than or equal to 50% and preferably greater than 60%;
- said production of the assembly being carried out by a technique for transferring an assembly of colloidal monolayers in a transfer liquid to the surface of a substrate;
- infiltration of said assembly of particles by at least one infiltration layer deposited by a conformal technique, making it possible to deposit said infiltration layer around said particles and to close off said porosity, open before this deposition step, in the form of pores that are not connected to one another;
- said infiltration being carried out by (ALD) for "Atomic Layer Deposition", or by plasma-enhanced chemical vapor deposition (PECVD) or chemical vapour deposition (CVD) or low pressure chemical vapour deposition (LPCVD).

16. Process for producing an encapsulation device according to claim 15, **characterized in that** the transfer technique is a Langmuir Blodgett or a Langmuir Shaefer transfer technique.

FIG.1a

FIG.1b

FIG.1c

FIG.2a

FIG.2b

FIG.3

FIG.4

## FIG.5a

$$t_{infiltration} = 2r/\sqrt{3} - r$$

$$2r/\sqrt{3}$$

$$30°$$

$$r$$

## FIG.5b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2003094256 A
- WO 2008094352 A
- WO 2008057045 A
- WO 2013062486 A

**Littérature non-brevet citée dans la description**

- **DAYANG WANG et al.** Synthesis of Macroporous Titania and Inorganic Composite Materials from Coated Colloidal SpheresA Novel Route to Tune Pore Morphology. *Chemistry of materials,* 01 Février 2001, vol. 13 (2), 364-371
- *Materials Science and Engineering B,* 2010, vol. 169, 43-48
- *IEEE transactions on advanced packaging,* vol. 30 (4), 712-724
- **GORHAM W. F.** A New, General Synthetic Method for the Preparation of Linear Poly-p-xylylene. *J. Polym. Sci. Part A-1,* 1966, vol. 4, 3027-3039